# EUROPEAN PATENT APPLICATION

(11) **EP 4 560 897 A1**
(43) Date of publication of application: **28.05.2025**
(21) Application number: 23211363.9
(22) Date of filing: 22.11.2023
(51) Int. Cl.: H02K 11/042, H02K 15/00, H02K 19/38, H05K 3/46, H02K 7/00, H01R 12/77, H01R 43/16, H01F 38/18

(54) **A METHOD FOR MANUFACTURING A RECTIFIER BOARD FOR AN ELECTRICALLY EXCITED ROTOR**

(71) Applicant: Polestar Performance AB, 405 31 Gothenburg (SE)
(72) Inventor: HOHLFÄLT, Peter, 475 37 Bohus-Björkö (SE)
(74) Representative: Zacco Sweden AB

(57) **Abstract**

The present disclosure relates to a rectifier board (1) arranged to provide DC current to windings (240) of a rotor (200), the rectifier board (1) comprising a first substrate (5), a trace routed conductive layer (3) positioned at a first surface (5a) of said first substrate (5), switching and control components (6) arranged to rectify AC power to DC power. Further, a first and a second edge portion (3a, 3b) of said conductive layer (3) are adapted, thereby being prepared to be electrically in contact with a transformer device (7) or a rotor winding (240), each edge portion (3a, 3b) being arranged to serve as a first and a second busbar. The disclosure further relates to methods related to such a rectifier board and a rotor comprising such a rectifier board.

## Description

### TECHNICAL FIELD

The present disclosure relates to a method for manufacturing a rectifier board, a method for manufacturing an electrically excited rotor and a rectifier board.

### BACKGROUND

In an electric vehicle, the rotor and stator are vital components of the electric motor that drives the vehicle's wheels. The rotor is the rotating part of the motor, typically made of a series of electromagnets, which are energized by electrical current. As the rotor spins, it generates a magnetic field that interacts with the stator. The stator is the stationary part of the motor, typically consisting of a windings wound around a core. The rotor and stator work together to convert electrical energy stored in the EV's battery into mechanical energy to drive the vehicle, making them critical components of the EV powertrain.

Permanent magnets used in rotors are not considered environmentally friendly for several reasons. First, the production of permanent magnets involves mining and refining of rare earth elements, which can cause environmental degradation and pollution. Also, permanent magnets can pose challenges in recycling and disposal, as they contain hazardous materials that can potentially harm the environment if not handled properly. Therefore, while permanent magnets have many technological benefits, their production and use can have negative environmental implications that need to be carefully managed.

Based on the above, electrically excited rotors using windings around the rotor core are considered to be more environmental friendly compared to permanent magnet rotors. However, the use of an electrically excited rotor requires electronic circuitry and other components which lead to additional steps during manufacturing. For example, the electronic circuitry comprises a rectifier board and busbars which enable the windings of the rotor to receive direct current. In order to manufacture and assemble these components, there are several production steps needed which make the end-product more costly and/or timely to produce. Additionally, the end-product is usually sensitive to centrifugal forces arising upon rotation of the rotor.

Therefore, it would be desirable to provide an improved method for manufacturing a rectifier board for an electrically excited rotor which is less costly and more time-efficient. Preferably, such a method should provide a more durable rectifier board.

### SUMMARY

It is therefore an object of the present disclosure to alleviate at least some of the mentioned drawbacks to provide a method for manufacturing a rectifier board with busbars embedded to the rectifier board. Further, the present disclosure provides a method for manufacturing a rotor with such a rectifier board. Moreover, the present disclosure discloses to a rectifier board and a rotor.

The present disclosure relates to a method for manufacturing a rectifier board for an electrically excited rotor comprising the steps of providing a first substrate having a first and second side portion and an intermediate portion between said first and second side portion. Further, the substrate comprises a (single-step layed) conductive layer at a first surface thereof i.e. a copper clad board may be provided. Further, the method comprises the step of trace routing said conductive layer. Further, the method comprises the step of attaching switching and control components to said intermediate portion of said first substrate. Further, the method comprises adapting a first and a second edge portion of said conductive layer relative the first substrate to thereby prepare said first and second side portions to be electrically in contact with a transformer device or a rotor winding, each edge portion being arranged to serve as a first and a second busbar. The term "electrically in contact" may be interchanged with "in direct/physical contact".

It should be noted that the steps of the method may be performed in any suitable order not limited to the aforementioned order. For example, the step of adapting may be performed before trace routing. Also, the step of attaching switching and control components may be performed prior to trace routing.

The trace routing may be performed by e.g. an etching process to remove parts of the conductive layer and expose the traces and the edge portions. The etching process may be performed based on a pre-defined layout of traces, component placements and said first and second edge portion. Thus, after the etching process, the copper traces according to the layout design and the edge portions are provided on said first surface of the substrate.

Accordingly, the busbars may be integral with the conductive layer, thereby being embedded to the rectifier board. An advantage of the method is that it provides a more durable rectifier board as the busbars are securely attached to the rectifier board. Further, it provides a more rapid manufacturing as the conductive layer both serves as busbars and the conductive track of the rectifier board. Accordingly, there is no need to attach the busbars separately e.g. by fastening means. Hence, the trace routing may be performed to provide conductive traces at a region of said conductive layer associated to said intermediate portion and to provide/maintain the conductive layer at edge portions thereof, thereby maintaining the conductive layer at a region associated with the side portions of the first substrate.

It should be noted that the first and second edge portions, or other edge portions such as a third and a fourth edge portion of the conductive layer may be further utilized. In other words, the step of adapting may be iterated to form a third and a fourth busbar. Accordingly, the step of adapting may comprise to adapt said first and second edge portion, and/or any other portion of said conductive layer relative the first substrate to thereby prepare said first and second edge portion to serve as a first, a second, a third and a fourth busbar. Thereby, the rectifier board may comprise four busbars, two of which are prepared to be in contact with said transformer device, and two of which are prepared to be in contact with said rotor winding. However, in some aspects, two busbars are prepared in accordance with the method herein wherein the other two busbars may be attached separately.

The step of trace routing may be performed to provide a (pre-defined) conductive trace and a conductive region at said edge portions of said conductive layer that defines said busbars. Accordingly, the trace routing may enable, when said switching and control components are attached thereto, the rectifier board to be configured/operable to obtain, by the busbars, alternating current (AC) power from a transmitting device and/or be operable to, by the busbars, transmit direct current (DC) power from the rectifier board to windings of a rotor. Accordingly, the conductive trace may also comprise pads/cavities for switching and control component placement.

Accordingly, the attachment of the switching and control components may be performed to conform with said trace routing. The attachment may be done either prior to or after the conductive traces accomplished by the trace routing is provided.

Accordingly, as apparent, the steps of the method herein may be performed in any suitable order and is not limited by the order as disclosed.

The step of adapting may comprise bending each of said first and second edge portion of said conductive layer relative the first substrate. The first and second edge portion may be bent for 65-140 degrees, preferably, about 90 degrees. Hence, the term "adapting" may be interchanged with "bending". Accordingly, this will allow the edge portions to serve/define as a first and a second busbar. The bending may be performed in order to prepare the side portions to attach to a transformer device or a rotor winding.

Each edge portion of the conductive layer may be positioned on top of a corresponding side portion of said first substrate to form a first and a (opposite) second multilayer portion. I.e. the first multilayer portion being formed by (the lamination of) the first edge portion and the first side portion, the second multilayer structure being formed by (a lamination of) the second edge portion and the second side portion. Accordingly, during the step of adapting, the method may comprise adapting each of the first and the second multilayer portion relative the intermediate portion of said first substrate.

In some aspects, the method further comprises, prior to the step of adapting; forming/laminating e.g. by bonding but preferably by (over)molding a second substrate on top of said conductive layer, the second substrate overlaying at least said first and second edge portions of said conductive layer, wherein each multilayer portion is defined by that each edge portion is sandwiched by corresponding parts (side portions) of said first and second substrate. Further, the method comprises adapting (a part of each multilayer portion which comprises said first and second edge portions) the edge portions relative the intermediate portion of the first substrate.

An advantage of this is that the edge portions, which are adapted to serve as busbars, will be substrate-embedded. Accordingly, they will be protected in an improved manner without increasing manufacturing complexity to any sizeable extent.

The substrate may be a flexible substrate formed by a flexible substrate material such as a polyimide-based material, polyester-based material or any other suitable flexible material allowing the substrate to be bent without braking. The conductive layer may be a copper layer.

In some aspects, the side portions of the first substrate (i.e. parts underlaying the edge portions of the conductive layer) is flexible and/or at least the first and second side portion of the second substrate overlaying the first and second edge portions are flexible. Accordingly, the intermediate portions may be more rigid compared to the side portions.

Edge portions of said conductive layer may according to some aspects herein, protrude beyond the perimeter of said substrate. Accordingly, the conductive layer may be applied so that it protrudes beyond the substrate enabling the protruding part to be utilized as busbars. Accordingly, the trace routing may be performed to dimension/adapt the rectifier board to enable utilization of the edge portions as busbars.

The method may in some aspects herein, after the step of adapting, comprise the step of enclosing the first and second busbar by at least one dielectric socket. The dielectric socket may be dimensioned and adapted to be inserted into a hollow rotor shaft. The dielectric socket may have a diameter corresponding to the diameter of the hollow rotor shaft for enabling press-fit insertion therein.

In some aspects of the present disclosure, the first and second edge portions of the conductive layer covers at least a part of corresponding side portions of said first substrate, wherein the method comprises, prior to adapting, removing part of the first and the second side portions overlayed by the first and second edge portions.

Accordingly, the edge portions of the conductive layer which is intended to be utilized as first and second busbars may be provided in several manners as explained in the aforementioned disclosure. Accordingly, the busbars may be provided by that:
(i) the edge portions form multilayer portions with the first substrate, thereby being adapted to be bent together with the first substrate;
(ii) the edge portions form a multilayer portions with the first and the second substrate, so that the edge portions are sandwiched between corresponding parts of the first and second substrate. Then, the edge portions are bent with the first and second substrate;
(iii) the edge portions are not attached to any substrate and are therefore bent without affecting any substrate.

In any of the aspects, the method may comprise, prior to, or during the step of adapting strip forming each first and second busbar. The strip forming may be performed to dimension (e.g. by adapting width/length) the busbars to be able to carry/transfer a pre-defined amount/magnitude of AC or DC power. In some aspects, the first and/or second substrate may be strip-formed to remove excess parts .

The step of trace routing may be performed to enable the switching and control components to, when attached to said conductive surface, operate in accordance with a specific design/layout requirement and to enable said edge portions to serve as said first and second busbar.

The present disclosure also provides a method for manufacturing an electrically excited rotor for an electric motor comprising the steps of providing an annular rotor core comprising a circumferentially distributed winding. Further, the method comprises providing a hollow rotor shaft accommodated by said annular rotor core, the rotor shaft extending axially along a centre axis. Further, the method comprises to provide providing a transformer device. The transformer device may comprise a rotary part attached to the rotor shaft and a static part attached to a fixed surface. The first part may be arranged to obtain AC power from a power source (such as the vehicle battery pack) and contactless, preferably inductively, transfer said AC power to the rotary part.

Further, the method comprises forming a rectifier board by forming a first substrate having a first and second side portion and an intermediate portion between said first and second side portion. Further, forming the board comprises providing a (single-step layed) conductive layer at a first surface of said first substrate and trace routing said conductive layer. Further, forming the board comprises attaching switching and control components to said intermediate portion of said first substrate and adapting, preferably by bending, a first and a second edge portion of said conductive layer relative the first substrate, thereby preparing said first and second side portions to be electrically in contact with said transformer device, each edge portion being arranged to serve as a first and a second busbar.

The method further comprises inserting said rectifier board into said hollow rotor shaft and connecting said first and second busbar to said transformer device or said winding and further connecting a third and a fourth busbar between the rectifier board and the other one of said transformer device and said winding. Accordingly, advantageously, at least two busbars may be formed in a single production step.

An advantage of the method is that it allows for a straightforward and convenient manufacturing process which provides a compact and durable rotor.

In some aspects, the rectifier board is attached to abut a base of said hollow rotor shaft. This advantageously allow the rectifier board to be more securely attached thereto. The rectifier board may be attached by fastening means such as screws, bolts or adhesive.

Prior to inserting the rectifier board into said hollow rotor shaft the rectifier board and the transformer device may be inserted into a dielectric socket for shielding the rectifier board and the transformer device from components of the shaft.

The present disclosure further provides a rectifier board arranged to provide DC current to windings of a rotor, the rectifier board comprising a first substrate having a first and second side portion and an intermediate portion between said first and second side portion. Further, the rectifier board comprises a (single-step layed) conductive layer positioned at a first surface of said first substrate, the layer being trace routed at a region associated with said intermediate portion of said first substrate. Further, the rectifier board comprises switching and control components arranged to rectify AC power to DC power, the switching and control components being attached to said intermediate portion of said first substrate. Further, the first and second edge portion of said conductive layer are adapted, preferably by being bent/deformed, relative the first substrate, thereby being prepared to be electrically in contact with a transformer device or a rotor winding, each edge portion being arranged to serve as a first and a second busbar.

The rectifier board provides a durable and compact structure.

The present disclosure further relates to an electrically excited rotor for an electric motor comprising an annular rotor core comprising a circumferentially distributed winding, a hollow rotor shaft accommodated by said annular rotor core, the rotor shaft extending axially along a centre axis. Further, the rotor comprises a transformer device and the rectifier board according to any aspect herein positioned within said rotor shaft. Further, the transformer device or said winding are connected to said first and second busbar, wherein a third and a fourth busbar are connected between the rectifier board and the other one of said transformer device and said winding.

The present disclosure further relates to an electric motor comprising the electrically excited rotor according to any aspect herein. Further, the present disclosure relates to an electric vehicle comprising such an electric motor.

### BRIEF DESCRIPTION OF THE DRAWINGS

These and other features and advantages of the present disclosure will now be further clarified and described in more detail, with reference to the appended drawings;
- Figure 1: illustrates schematically a method for manufacturing a rectifier board in accordance with some aspects of the present disclosure;
- Figure 2: illustrates, in the form of a flowchart, a method for manufacturing a rectifier board in accordance with some aspects of the present disclosure;
- Figure 3: illustrates a side view of a rectifier board in accordance with some aspects of the present disclosure;
- Figure 4: illustrates from a side view the step of adapting the edge portions of the conductive layer in accordance with some aspects of the present disclosure;
- Figure 5: illustrates schematically a method for manufacturing a rectifier board in accordance with some aspects of the present disclosure;
- Figure 6: illustrates schematically a flowchart of a method for manufacturing a rectifier board in accordance with some aspects of the present disclosure;
- Figure 7: illustrates schematically a flowchart possible substeps of the method step 308 for manufacturing a rectifier board in accordance with some aspects of the present disclosure;
- Figure 8: illustrates a rotor shaft comprising a rectifier board inserted therein in accordance with some aspects of the present disclosure; and
- Figure 9: illustrates an exploded objective view of a rotor, a rectifier board and a transformer device in accordance with some aspects of the present disclosure.

### DETAILED DESCRIPTION

In the following detailed description, some embodiments of the present disclosure will be described. However, it is to be understood that features of the different embodiments are exchangeable between the embodiments and may be combined in different ways, unless anything else is specifically indicated. Even though in the following description, numerous specific details are set forth to provide a more thorough understanding of the present disclosure, it will be apparent to one skilled in the art that the present disclosure may be practiced without these specific details. In other instances, well known constructions or functions are not described in detail, so as not to obscure the present disclosure.

It is also to be understood that the terminology used herein is for purpose of describing particular aspects only, and is not intended to be limiting. It should be noted that, as used in the specification and the appended claim, the articles "a", "an", "the", and "said" are intended to mean that there are one or more of the elements unless the context clearly dictates otherwise. Thus, for example, reference to "a unit" or "the unit" may refer to more than one unit in some contexts, and the like. Furthermore, the words "comprising", "including", "containing" do not exclude other elements or steps. It should be emphasized that the term "comprises/comprising" when used in this specification is taken to specify the presence of stated features, integers, steps, or components. It does not preclude the presence or addition of one or more other features, integers, steps, components, or groups thereof. The term "and/or" is to be interpreted as meaning "both" as well and each as an alternative. More specifically, the wording "one or more" of a set of elements (as in "one or more of A, B and C" or "at least one of A, B and C") is to be interpreted as either a conjunctive or disjunctive logic. Put differently, it may refer either to all elements, one element or combination of two or more elements of a set of elements. For example, the wording "A, B and C" may be interpreted as A or B or C, A and B and C, A and B, B and C, or A and C.

It will also be understood that, although the term first, second, etc. may be used herein to describe various elements or features, these elements should not be limited by these terms. These terms are only used to distinguish one element from another. For example, a first element could be termed a second element, and, similarly, a second element could be termed a first element, without departing from the scope of the embodiments. The first element and the second element are both elements, but they are not the same element.

The term "electric vehicle" as used herein may refer to an all-electric vehicle, also referred to as an EV, a plug-in hybrid vehicle, also referred to as a PHEV, or a hybrid vehicle, also referred to as a HEV, where a hybrid vehicle refers to a vehicle utilizing multiple propulsion sources one of which is an electric drive system.

The term "hollow rotor shaft" may refer to that the rotor shaft comprises a void/space at the interior of the rotor shaft. The rotor shaft may at one end be connected to an output shaft of an EV.

The expression "method for manufacturing a rectifier board for an electrically excited rotor" may be interchanged with "method for manufacturing a rectifier board arranged to be coupled to an electrically excited rotor" or "method for manufacturing a rectifier board arranged for an electrically excited rotor".

The term "first and second edge portion" may be interchanged with first and second busbar.

The term "busbar" may refer to an electrical conductor typically made of copper or aluminium used to distribute electric power. The term busbar as used herein may refer to a flat rigid conductor.

The term "rotor" herein may refer to an electrically excited rotor. An electrically excited rotor being a rotor that is magnetized by an external electrical source. Preferably, DC power received from a rectifier board.

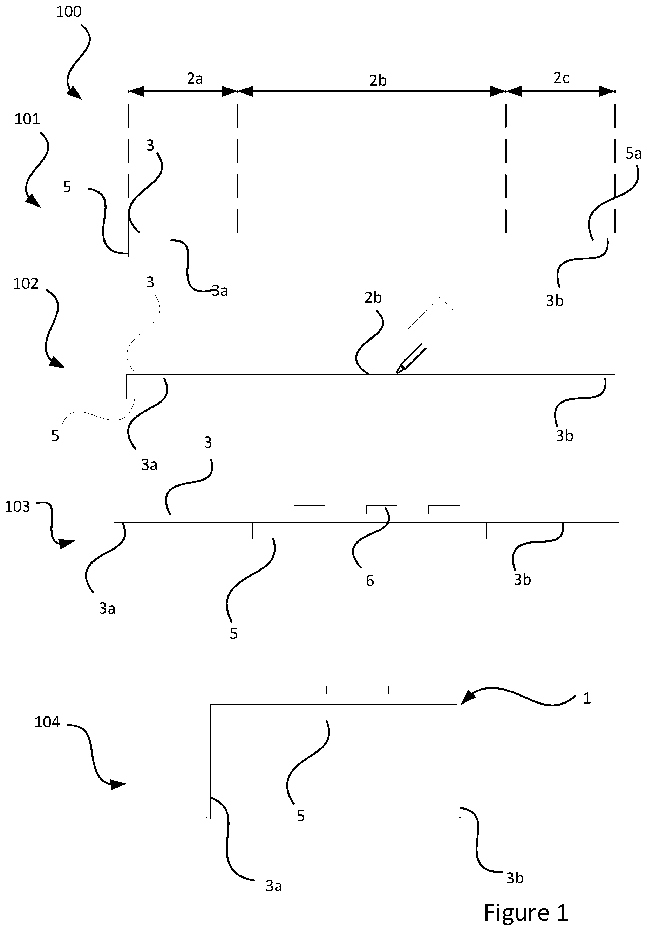

Figure 1 illustrates a method 100 for manufacturing a rectifier board for an electrically excited rotor in the form of a graphical flowchart that depicts the elements from a side-view. Figure 1 illustrates that the method 100 comprises the steps of providing 101 a first substrate 5 having a first and second side portion 2a, 2c and an intermediate portion 2b between said first and second side portion 2a, 2c. Further, the first substrate 5 comprises a conductive layer 3 at a first surface 5a thereof.

Figure 1 further illustrates that the method 100 comprises the step of trace routing 102 said conductive layer 3. Accordingly, the step of trace routing may comprise to (e.g. by photolithography) provide traces which are transferred to the substrate by e.g. etching. Further, prior to etching the substrate may be subjected to a development process. Further, trace routing may also comprise to drill holes for component placement.

Further, as illustrated in Figure 1, the method 100 comprises attaching 103 switching and control components 6 to said intermediate portion 2b of said first substrate 5. The switching and control components 6 may comprise rectifier bridges, diodes, transistors, thyristors, gate drivers, control circuits (e.g. micro controllers), voltage regulators, sensor devices and any other suitable components for enabling the rectifier board to convert AC power to DC power. Further, the switching and control components may comprise protection components such as fuses and circuit breakers.

Further, the method 100 comprises adapting 104 a first and a second edge portion 3a, 3b of said conductive layer 3 relative the first substrate 5 to prepare said first and second side portions 2a, 2c to be electrically/directly in contact with a transformer device 7 or a rotor winding 8, each edge portion 3a, 3b being arranged to serve as a first and a second busbar.

Accordingly, as illustrated in Figure 1, the step of adapting may comprise to bend said first and second edge portion 3a, 3b of said conductive layer 3 relative the first substrate 5. Thereby, the first edge portion 3a may serve as a first busbar and the second edge portion 3b may serve as a second busbar. The busbars may be connected between the rectifier board and a transformer device such that one busbar may serve to carry AC power to the rectifier while the other busbar is a neutral conductor. However, in some aspects the busbars may be connected between the rectifier board and the rotor winding such that one busbar may, at one end, is connected to a positive terminal of the rectifier board and the other, at one end, to a negative terminal of the rectifier board. Accordingly, the other ends of the busbars may be adapted to connect to the rotor winding.

As illustrated in Figure 1, the first and the second busbar 3a, 3b may be bent to prepare the busbars 3a, 3b to be attached to a transformer device which is intended to be parallel aligned with the rectifier board. Figure 1 further illustrates that the edge portions 3a, 3b of the conductive layer 3 protrude beyond the perimeter of said substrate 5. The edge portion 3a, 3b may protrude beyond the perimeter of said substrate 5 prior to the step of trace routing 103 or in some aspects, the conductive layer 3 may be pre-fabricated to the substrate 5 such that the edge portions 3a, 3b protrude beyond the perimeters thereof.

The step of trace routing 103 as illustrated in Figure 1 may be performed to enable the rectifier board 1 to be operable to obtain, by the first and the second edge portion 3a, 3b serving as a first and a second busbar, AC power from a transmitting device. Alternatively, the step of trace routing 103 may be performed to enable the rectifier board 1 to be operable to transmit, by the first and the second edge portion 3a, 3b serving as a first and a second busbar, DC power to windings of a rotor. In other words, the trace routing 103 may be performed to provide a conductive routing, which, when the switching and control components 6 are attached to the rectifier board 1 enable the rectifier board 1 to receive AC power and convert AC power to DC power. The conductive routing may be provided in accordance with a pre-defined scheme and the switching and control components 6 may be attached in accordance with said pre-defined scheme.

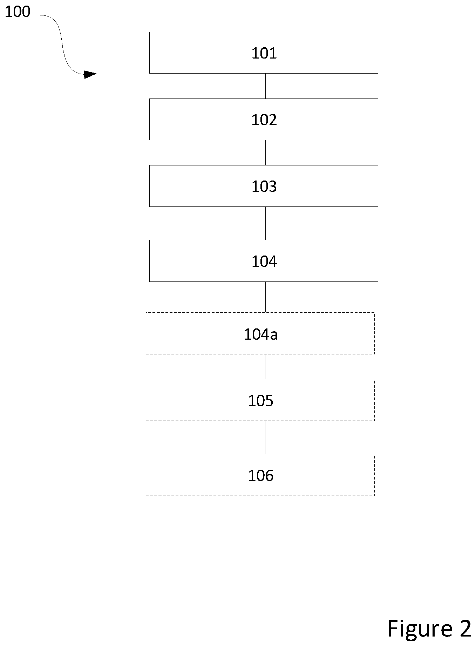

Figure 2 illustrates the method 100 in the form of a schematic flowchart comprising the steps 100-104 as described in the aforementioned. However, Figure 2 further discloses that the method may comprise the steps of enclosing 105 the first and second busbar by at least one dielectric socket. Further, Figure 2 illustrates that the method 100 may comprise the steps of removing 104a part of the first and the second side portions overlayed by the first and second edge portions. Moreover, Figure 2 illustrates that the method 100 may comprise the step of strip forming 106 each first and second busbar so to adapt the dimensions of each busbar.

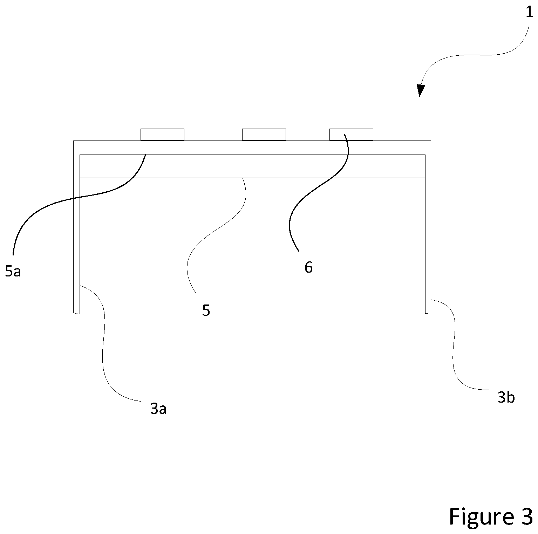

Figure 3 illustrates a side view of a rectifier board 1. The rectifier board 1 may be obtained by the method 100 as illustrated in Figure 1. The rectifier board 1 comprises a first substrate 5 and a conductive layer 3 positioned at a first surface 5a of said first substrate 5. The layer 3 is trace routed. Further, switching and control components 6 arranged to rectify AC power to DC power are attached to the first substrate 5 in cooperation with said trace routed layer 3. Further, a first and a second edge portion 3a, 3b of said conductive layer 3 are adapted by being bent relative the first substrate 5, thereby being prepared to be electrically in contact with a transformer device or a rotor winding, each edge portion 3a, 3b being arranged to serve as a first and a second busbar.

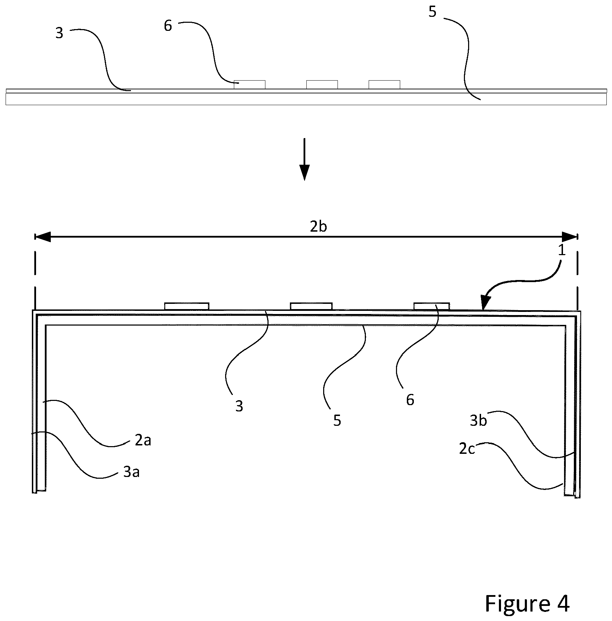

Figure 4 illustrates an aspect of the method 100 during the step of adapting in which each edge portion 3a, 3b is positioned on top of a corresponding side portion 2a, 2c of said first substrate 5 to form a first and a second multilayer portion. Figure 4 depicts the elements from a side-view. Thus, when adapting, preferably by bending, the method 100 comprises (jointly) adapting each of the first and the second multilayer portion relative the intermediate portion 2b of said first substrate 5. Thus, as illustrated in Figure 4, the two multilayer portions are bent so that the sides 2a, 2c supports the busbars 3a, 3b. The substrate 5 of Figure 4 may be flexible at least at said side portions 2a, 2c.

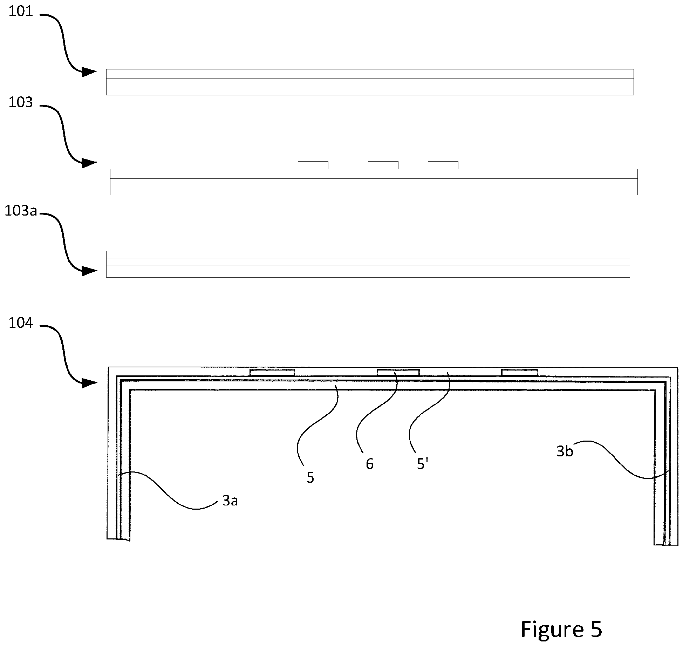

Figure 5 illustrates another aspect of the method 100. In Figure 5 the steps of providing 101, attaching and adapting 104 are illustrated from a side view. Further, Figure 5 illustrates that prior to adapting 104, the method 100 may comprise the step of forming 103a a second substrate 5' on top of said conductive layer 3, the second substrate 5' overlaying at least said first and second edge portions 3a, 3b of said conductive layer 3, wherein each multilayer portion is defined by that each edge portion 3a, 3b is sandwiched by corresponding parts of said first and second substrate 5, 5'. Accordingly, the busbars 3a, 3b are thereby enclosed by substrate material. An end-portion of each multilayer portion may be adapted to arrange the busbars 3a, 3b for connection to a transformer.

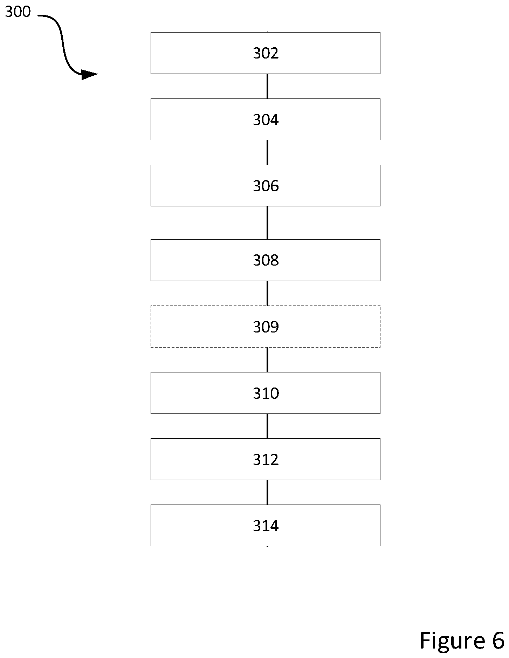

Figure 6 illustrates in the form of a flowchart a method 300 for manufacturing an electrically excited rotor for an electric motor comprising the steps of providing 302 an annular rotor core comprising a circumferentially distributed winding. Accordingly, the rotor core comprises a winding distributed about its circumference. The winding may be any suitable type of winding such as hairpin winding. Further, the method comprises the step of providing 304 a hollow rotor shaft accommodated by said annular rotor core. The hollow rotor shaft having an accessible interior. Further, the rotor shaft extends axially along a centre axis thereof. Further, the method comprises the step of providing 306 a transformer device. The transformer device comprising a first and a second part for transferring AC power inductively between the parts.

Further, the method 300 comprises the step of forming 308 a rectifier board. Moreover, the method comprises the steps of inserting 310 said rectifier board into said hollow rotor shaft, connecting 312 said first and second busbar to said transformer device or said winding and connecting 314 a third and a fourth busbar between the rectifier board and the other one of said transformer device and said winding.

The third and fourth busbar may attached separately to the rectifier board. The third and fourth busbar may be attached to the rectifier board during the step of attaching 308c switching and control components to the rectifier board.

The method 300 may further comprise, prior to inserting 310 the rectifier board into said hollow rotor shaft, inserting 309 the rectifier board and (at least a part of) the transformer device into a dielectric socket. The dielectric socket may be arranged to at least circumferentially protect the board and the transformer device from external conductive components, dust, moisture etc.

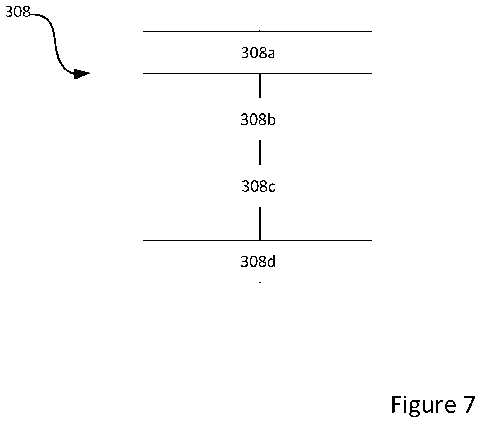

Figure 7 schematically in the form of a flowchart illustrates the method step 308 which comprises the step of providing 308a a first substrate having a first and second side portion and an intermediate portion between said first and second side portion, wherein the first substrate comprises a conductive layer at a first surface thereof. Further, the step of forming 308 further comprises trace routing 308b said conductive layer. Further, the step of forming 308 comprises attaching 308c switching and control components to said intermediate portion of said first substrate. Further, the step of forming 08 comprise adapting 308d, preferably by bending, a first and a second edge portion of said conductive layer relative the first substrate, thereby preparing said first and second side portions to be electrically in contact with said transformer device, each edge portion being arranged to serve as a first and a second busbar.

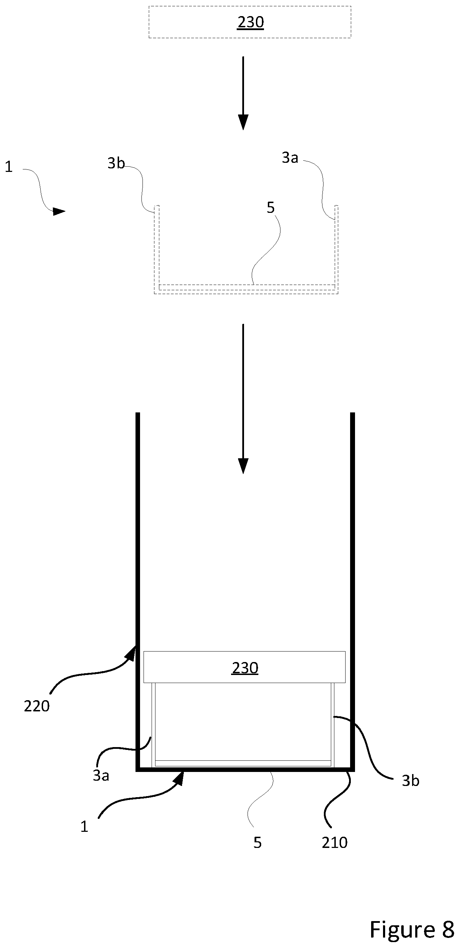

Figure 8 illustrates, schematically a flowchart depicting the rectifier board 1 according to any aspect herein being inserted into a hollow rotor shaft 220 of a rotor. Accordingly, Figure 8 illustrates that the rectifier board is, when inserted abutting/contacting a base 210 of said hollow rotor shaft 220 at one end of the shaft. Further, Figure 8 illustrates that a (schematically illustrated) transformer device 230 is connected to the busbars 3a, 3b of the rectifier board 1 for transferring AC power to the rectifier board 1 which is subsequently rectified to DC power and supplied to rotor windings.

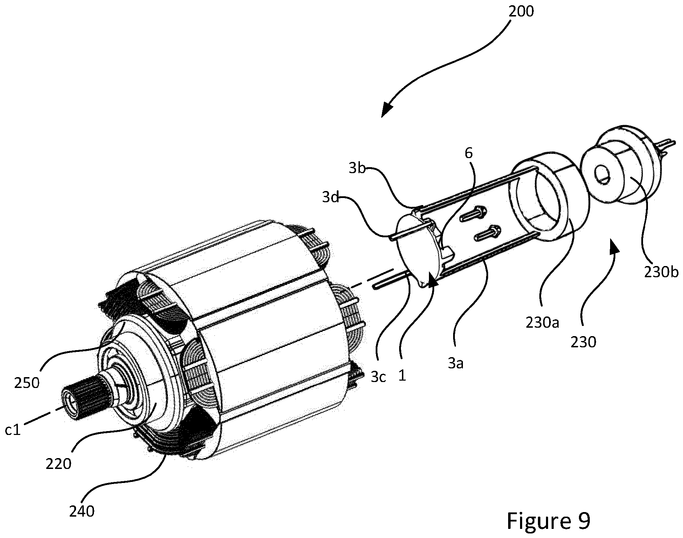

Figure 9 illustrates an exploded objective view of a rotor 200 having a hollow rotor shaft 220 and a rectifier board 1 coupled to a transformer device 230. The rectifier board 1 is arranged to be inserted into the hollow rotor shaft 220.

As illustrated in Figure 9, the rectifier board comprises a first and a second busbar 3a, 3b which may be manufactured by the methods 100, 300 in accordance with any aspect herein. Figure 9 further illustrates that the busbars 3a, 3b are directly connected to a first part 230a of said transformer 230. The busbars 3a, 3b may be arranged to be inserted into a receiving socket of the first part 230a of said transformer 230, preferably by press-fit. Accordingly, the step of adapting may comprise to adapt/configuring end portions of each busbar (which is intended to be coupled to the transformer device 230) for press-fit insertion into a corresponding socket of said first part 230a of said transformer 230. Hence, the step of connecting 312 as disclosed in relation to Figure 6 may comprise to press-fit connect the first and second busbar 3a, 3b to corresponding sockets of said first part 230a of said transformer device 230. Further, the transformer 230 comprises a second part 230b which is arranged to inductively transfer AC power to the first part 230a, preferably by radial power transfer. Accordingly, the first and the second parts 230a-b may each comprise a coil-structure for inductive transfer of AC power therebetween. The first part 230a may radially enclose the second part 230b. The second part 230b may be a stationary part connected to a stationary component of an electric motor (such as a frame thereof) which said rotor 200 is arranged to form a part of. The first part 230a may be a rotary part which is arranged to rotate with the rotor shaft 220. Hence, the first part 230a may be attached to the interior of the rotor shaft 230a. The second part 230b may receive AC power from a power source, i.e. a battery pack, of e.g. an electric vehicle.

Figure 9 further illustrates that the rectifier board 1 comprises a third and a fourth busbar 3c, 3d arranged to contact a rotor winding 240. Hence, the busbars 3c-d may protrude out from the rotor shaft to contact the winding 240 to power the winding to simulate a permanent magnetic field configured to interact with the magnetic field of a stator. Accordingly, the rectifier board 1 may be arranged to receive AC power from the transformer device 230.

Rectify said AC power to DC power and transmit the DC power to the winding 240 of the rotor 200.

Generally, the rectifier board 1, and rotor 200 of any aspect herein may be arranged to be utilized in an electric motor of an electric vehicle such that the rotor 200 is accommodated by a stator. Such an electric vehicle may comprise a battery pack a number of other electrical components, including an electrical current transmission system, safety system, battery management system, current management system, and a battery busbar interconnecting the various components. Further, the electric vehicle may comprise an electronic control unit (ECU) in order to control the electric motor. The ECU or components thereof can comprise or include various modules, each of which is constructed, programmed, configured, or otherwise adapted to autonomously carry out a function or set of functions. The electric motor may comprise a stator which can be of any suitable type comprising an annular core that comprises stator windings distributed circumferentially about the annular core. Each stator enclosing a rotor according to any aspect herein. Further, each stator may have any suitable number of stator poles and phases. Each stator being arranged to receive AC power.

## Claims

1. A method (100) for manufacturing a rectifier board (1) for an electrically excited rotor comprising:
- providing (101) a first substrate (5) having a first and second side portion (2a, 2c) and an intermediate portion (2b) between said first and second side portion (2a, 2c), wherein the first substrate (5) comprises a conductive layer (3) at a first surface (5a) thereof;
- trace routing (102) said conductive layer (3);
- attaching (103) switching and control components (6) to said intermediate portion (2b) of said first substrate (5);
- adapting (104) a first and a second edge portion (3a, 3b) of said conductive layer (3) relative the first substrate (5) to prepare said first and second side portions (2a, 2c) to be electrically in contact with a transformer device (7) or a rotor winding (8), each edge portion (3a, 3b) being arranged to serve as a first and a second busbar.

2. The method (100) according to claim 1, wherein the step of adapting (104) comprises bending said first and second edge portion (3a, 3b) of said conductive layer (3) relative the first substrate (5).

3. The method (100) according to claim 1 or 2, wherein each edge portion (3a, 3b) is positioned on top of a corresponding side portion (2a, 2c) of said first substrate (5), forming a first and a second multilayer portion, wherein when adapting (104), the method (100) comprises:
- adapting (104) each of the first and the second multilayer portion relative the intermediate portion (2b) of said first substrate (5).

4. The method (100) according to claim 3, wherein the method (100) further comprises, prior to adapting (104):
- forming (103a) a second substrate (5') on top of said conductive layer (3), the second substrate (5') overlaying at least said first and second edge portions (3a, 3b) of said conductive layer (3), wherein each multilayer portion is defined by that each edge portion (3a, 3b) is sandwiched by corresponding parts of said first and second substrate (5, 5').

5. The method (100) according to any of the preceding claims, wherein at least said first and second side portions (2a, 2c) of said first substrate (5) are flexible.

6. The method (100) according to claim 1, wherein said edge portions (3a, 3b) of said conductive layer (3) protrude beyond the perimeter of said substrate (5).

7. The method (100) according to any one of the preceding claims, wherein, after the step of adapting (104), the method (100) comprises:
- enclosing (105) the first and second busbar by at least one dielectric socket.

8. The method (100) according to any one of the preceding claims, wherein the first and second edge portions (3a, 3b) of the conductive layer (3) covers at least a part of corresponding side portions (2a, 2c) of said first substrate, wherein the method comprises, prior to or during the step of adapting (104):
- removing (104a) part of the first and the second side portions (2a, 2c) overlayed by the first and second edge portions (3a, 3b).

9. The method (100) according to any one of the preceding claims, wherein the method (100) comprises, prior to, or during the step of adapting (104):
- strip forming (106) each first and second busbar.

10. The method (100) according to any one of the preceding claims, wherein the step of trace routing (102) is performed to enable the rectifier board to be operable to
obtain, by the first and the second edge portion serving as a first and a second busbar, AC power from a transmitting device; or
to transmit, by the first and the second edge portion serving as a first and a second busbar, DC power to windings of a rotor.

11. A method (300) for manufacturing an electrically excited rotor for an electric motor comprising:
- providing (302) an annular rotor core comprising a circumferentially distributed winding;
- providing (304) a hollow rotor shaft accommodated by said annular rotor core, the rotor shaft extending axially along a centre axis;
- providing (306) a transformer device;
- forming (308) a rectifier board, forming a rectifier board comprising
∘ providing (308a) a first substrate having a first and second side portion and an intermediate portion between said first and second side portion, wherein the first substrate comprises a conductive layer at a first surface thereof;
∘ trace routing (308b) said conductive layer;;
∘ attaching (308c) switching and control components to said intermediate portion of said first substrate;
∘ adapting (308d), preferably by bending, a first and a second edge portion of said conductive layer relative the first substrate, thereby preparing said first and second side portions to be electrically in contact with said transformer device, each edge portion being arranged to serve as a first and a second busbar
- inserting (310) said rectifier board into said hollow rotor shaft
- connecting (312) said first and second busbar to said transformer device or said winding
- connecting (314) a third and a fourth busbar between the rectifier board and the other one of said transformer device and said winding.

12. The method (300) according to claim 11, wherein the rectifier board is attached to abut a base of said hollow rotor shaft.

13. The method (300) according to any one of the claims 11 or 12, wherein the method (300) comprises, prior to inserting (310) the rectifier board into said hollow rotor shaft (220);
- Inserting (309) the rectifier board and the transformer device into a dielectric socket.

14. A rectifier board (1) arranged to provide DC current to windings (240) of a rotor (200), the rectifier board (1) comprising;
- a first substrate (5)
- a trace routed conductive layer (3) positioned at a first surface (5a) of said first substrate (5);
- switching and control components (6) arranged to rectify AC power to DC power;
wherein a first and a second edge portion (3a, 3b) of said conductive layer (3) are adapted, preferably by being bent relative the first substrate (5), thereby being prepared to be electrically in contact with a transformer device (7) or a rotor winding (240), each edge portion (3a, 3b) being arranged to serve as a first and a second busbar.

15. An electrically excited rotor (200) for an electric motor comprising:
- an annular rotor core (250) comprising a circumferentially distributed winding (240);
- a hollow rotor shaft (220) accommodated by said annular rotor core (250), the rotor shaft (220) extending axially along a centre axis (c1);
- a transformer device (230);
- the rectifier board (1) according to claim 14, the rectifier board (1) being positioned within said rotor shaft (220),
wherein the transformer device (230) or said winding (240) are connected to said first and second busbar (3a, 3b), wherein a third and a fourth busbar (3c, 3d) are connected between the rectifier board (1) and the other one of said transformer device (230) and said winding (240).
